# EUROPEAN PATENT APPLICATION

(11) **EP 3 608 797 A1**
(43) Date of publication of application: **12.02.2020**
(21) Application number: 17904736.0
(22) Date of filing: 19.05.2017
(51) Int. Cl.: G06F 17/22

(54) **METHOD FOR CHECKING WHETHER BIM MODEL FILE IS CHANGED**

(30) Priority: 08.04.2017 CN 201710226217
(71) Applicant: Dalian Wanda Group Co., Ltd., Xigang District Dalian Liaoning 116011 (CN)
(72) Inventor: DING, Benxi, Beijing 100022 (CN); QI, Jie, Beijing 100022 (CN); LAI, Jianyan, Beijing 100022 (CN); YIN, Qiang, Beijing 100022 (CN); WANG, Fukui, Beijing 100022 (CN); SANG, Guoan, Beijing 100022 (CN); WU, Chunyu, Beijing 100022 (CN); CHEN, Tao, Beijing 100022 (CN); JI, Wenqing, Beijing 100022 (CN)
(74) Representative: Ipside
(86) International application number: PCT/CN2017/085044
(87) International publication number: WO 2018/184284

(57) **Abstract**

Disclosed in the present invention is a method for checking whether a BIM model file is changed. The method at least comprises the following steps: determining one of at least two BIM model files to be checked as a basic file; performing initial data processing of the at least two BIM model files to be checked; acquiring geometric vector information and attribute information of model components of the model files; comparing the geometric vector information and attribute information of model components of the files at the same position; and acquiring a change comparison table of the at least two BIM model files. The method of the present invention can quickly achieve version comparison by comparing geometric vector information of model components of model files comprising a massive amount of data. By comparing geometric information and all the attribute information of components of different versions at the same position, the invention determines whether components are changed and whether components of the files are deleted or added, and efficiently acquires a version change comparison table, thereby helping designers to view version changes.

## Description

### FIELD

The present disclosure relates to the field of data processing, and in particular to a method for checking whether a BIM (Building Information Modeling) model file is changed in a project.

### BACKGROUND

With the launch of various projects, a design institute or a construction company is faced with the problem of dealing with multiple engineering blueprints. During a construction process, the blueprints are critical, and various history versions of the blueprints of the project are required to be strictly monitored. At present, the above monitoring is mostly performed by manual examination, and the comparison of different versions of engineering files, even if not manually, is performed by using existing software. However, the current software is not specifically adapted. As the number of BIM model components is huge, and the changes between different versions of engineering files are complicated, there is a high error rate in the examination process. Therefore, in order to facilitate the strict control of the history versions of large engineering files, a new method for checking changes is required, with which different versions of engineering files can be quickly compared to find out the changes.

### SUMMARY

An object of the present disclosure is to provide a method for checking whether a BIM model file is changed, with which different versions of engineering files can be quickly compared to find out the changes therebetween.

In order to solve the above technical problem, a method for checking whether a BIM model file is changed is provided according to the present disclosure, which includes at least the following steps:
determining one of at least two to-be-checked BIM model files as a base file;
performing an initial data processing on the at least two to-be-checked BIM model files;
obtaining geometric vector information and attribute information of each model component in the BIM model files;
comparing the geometric vector information and attribute information of model components at the same position in respective BIM model files; and
obtaining a change and comparison table of the at least two BIM model files.

In the above method, hash algorithm is used to process the BIM model files in the initial data processing.

In the above method, information generated in the above steps is all stored in a container generated by the hash algorithm.

In the above method, steps of deducing a digital dictionary are protected in the hash algorithm.

In the above method, the step of comparing the geometric vector information and attribute information of the model components at the same position in respective BIM model files includes comparison to identify addition, deletion and consistency, which mainly includes:
generating a list of newly added component, if a component does not exist in the original base file and exists in a reference file;
generating a list of changed component, if the component exists in both the original base file and the reference file and the component in the original base file is inconsistent with the component in the reference file; and
generating a list of deleted component, if the component exists in the original base file and does not exist in the reference file.

Following beneficial effects can be achieved according to the present disclosure. With the method provided in the present disclosure, comparison of different versions of engineering files can be quickly implemented, by performing a pairwise comparison on geometric vector information on model components in the model files containing large amounts of data. By pairwise comparison on the geometric vector information and all attribute information of model components at the same position in different versions of BIM model file, it can be determined whether a component is changed and whether a component is deleted or added in a file, and a change and comparison table of the versions is obtained efficiently, making it easy for designers to view the changes in different versions of files.

### BRIEF DESCRIPTION OF THE DRAWINGS

Figure 1 is a flow chart of a method for checking whether a BIM model file is changed according to an embodiment of the present disclosure; and
Figure 2 is a flow of interface operations of a method according to an embodiment of the present disclosure.

### DETAILED DESCRIPTION OF EMBODIMENTS

The present disclosure is further described in detail below in conjunction with the embodiments and with reference to the drawings.

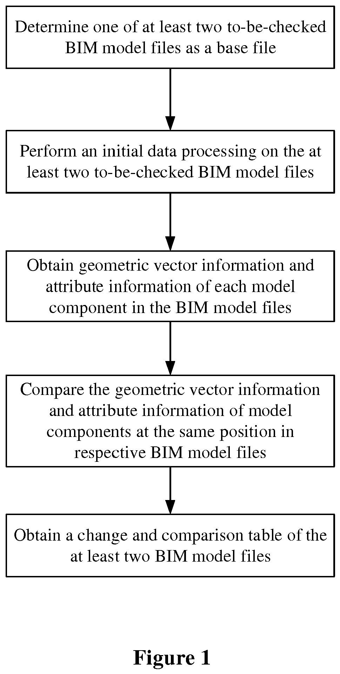

A method for checking whether a BIM model file is changed is provided according to an embodiment. Reference is made to Figure 1, which is a flow chart of a method for checking whether a BIM model file is changed according to the present disclosure. The method includes at least the following steps:
determining one of at least two BIM model files to be read as a base file;
performing an initial data processing on the at least two BIM model files to be checked;
obtaining geometric vector information and attribute information of each model component in the BIM model files;
comparing the geometric vector information and attribute information of model components at the same position in respective BIM model files; and
obtaining a change and comparison table of the at least two BIM model files.

In the present embodiment, hash algorithm is used to process the BIM model files in the initial data processing, and the information, which is generated in the above steps, is all stored in a container generated by the hash algorithm.

The present disclosure is described below with specific embodiments. In the method according to the present disclosure, a geometric data item of a to-be-checked model component is converted, as a data frame, into numbers according to a certain set algorithm (for example, converting information, such as points, lines and surfaces, into enumeration information). A remainder calculation is performed on a length of an array of the numbers to get a remainder, and the remainder is used as a next tag for the array. These numbers are stored in an array space with the digital subscript. The set algorithm may be implemented by using a solution in conventional art, and details thereof are not described herein.

In application, after a query command on a hash table (that is, an instruction to find whether there is a change between two versions of files) is received from a user, a hash function can be used to convert a data frame into an array with a tag corresponding to the data frame, to obtain a corresponding hashed value from the space. A hash table constantly changes with changes in input values. Therefore, an array positioning function in the hash algorithm can be fully used to determine a position of data, greatly improving the query speed.

In an embodiment, in checking a BIM model file, a to-be-checked object is quickly obtained by using a fast filter implemented by the hash algorithm and is stored in the container; the to-be-checked object is quickly extracted from the container by using a hash fast lookup algorithm; then a comparison between a current version of the object and a standard version of the object is performed; an object with changes is stored in the container implemented by the hash algorithm; and, the checking result is stored in a database in the present embodiment, to facilitate later extraction of data.

In the method provided according to the present disclosure, in order to better implement fast lookup with the hash (Hash) algorithm, multiple deductions are performed in the internal, such as deduction of a digital dictionary. The dictionary may be constructed by the following steps.

In step 1, a hash container in the database is initialized, for example, the initialization is performed as following:

```
     this.buckets = new int[prime]
```

In step 2, a to-be-tested container in the database is initialized, for example, the initialization is performed as following:

```
     this.entries = new Entry<TKey, TYalue >[prime]
```

In step 3, the capacity of each of the above initialized containers (the capacity of the Bucket and the entries) is a minimum prime number larger than a capacity of the dictionary.

In the above steps, this.buckets is mainly used for Hash collision, and this.entries is used to store content of the dictionary and identify the position of a next element.

In the embodiment of the present disclosure, an element may be added in the dictionary (Dictionary) by the following steps.

First, a collision is performed on a specified Bucket by using the Hash algorithm, and all the collided data on the same Bucket slot form a single link list; and then, by default the data in an Entries slot is arranged in an order in which the data is added. In the present embodiment, a dictionary query and query efficiency thereof depend on the number of collisions in the Hash algorithm, so the speed of the lookup by means of dictionary deduction is very fast.

How to add an element in the Dictionary is described hereinafter by taking the Dictionary<GeoObjectBase, List<Element>> for example.

First, the following is constructed:

```
     Dictionary<GeoObjectBase, List<Element>>dic = new Dictionary<GeoObjectBase,
 List<Element>> (6);
```

after initialization:
changes in the Bucket and entries within a set when adding an element,

```
publicenumEGeoObjType
     {
     e_PointObj=0,
     e_LinerObj,
     e_ArcObj,
     e_UnknownObj,
     }
     public override intGetHashCode()
     {
     Return (int)this. GeoObjType;
     }
     GeoObjectBase gobO = new GeoObjectBase();
     List<Element> IstElmO = new List<Element>();
     dic.Add(gob0, IstElmO):
```

afterwards, according to the Hash algorithm: assuming that gob0.GetHashCode()%7=2, the slot with a subscript of 2 in the buckets is collided, since Count is equal to 0, the element is placed on the 0th element in Entries, and Count is equal to 1 after the addition.

```
     GeoObjectBase gobl = new GeoObjectBase();
     List<Element> 1stElm1 = new List<Element>();
     dic.Add(gobl, 1stElm1):
```

afterwards, according to the Hash algorithm: assuming that gob1.GetHashCode()%7=2, the slot with a subscript of 2 in the buckets is collided again, since Count is not equal to -1, Count is equal to 1 in this case, so this newly added element is put into the array with the subscript of 1 in the entries, and the Buckets slot is oriented to entries with the subscript of 0 under the entry with the subscript of 1 that is under entries with the subscript of 1. Through the above, all the elements with the same HashCode form a link list, where the more collisions of elements there are, the longer the link list is, and the more time it takes.

```
     GeoObjectBase gob2 = new GeoObjectBase();
     List<Element> 1stElm2 = new List<Element>();
     dic.Add(gob2, 1stElm2):
```

afterwards, according to the Hash algorithm: assuming that gob2.GetHashCode()%7=3, Hash collision occurs at another slot, while the element is still added to the position of count+1.

The method in the present disclosure is further described below with a specific BIM model file checking process.

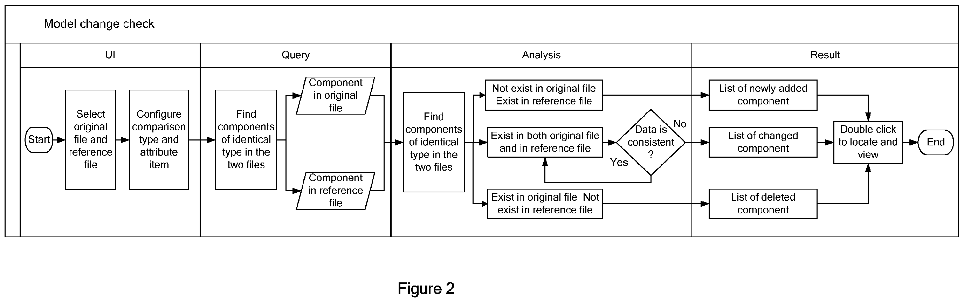

In the present embodiment, reference is made to Figure 1 and Figure 2 showing a flowchart of interface operations for the process of checking changes between BIM models in different versions of engineering model files (for example, building professional layer 1.0 and building professional layer 1.1).

One of at least two BIM model files to be read is determined as a base file. That is, one of the two files, for example, the file building professional layer 1.0, is determined as a base file, and the other file building professional layer 1.1 is determined as a to-be-checked file. In practical application, multiple model files may be checked at the same time by using the same principle. Therefore, checking two BIM model files is taken as an example for description in the present embodiment.

An initial data processing is performed on the at least two to-be-checked BIM model files. That is, the information in the two files is read, which includes identifying various professional categories: abstracting professional components, such as equipment, pipes and walls, in an object-oriented manner, classifying the professional components by geometric objects, such as points, straight lines and arcs, packaging geometric parameters of the components and providing a common "aligned comparison" interface.

Geometric vector information and attribute information of each model component in the BIM model files are obtained. That is, initialized data is read, and the digitalized geometric vector information and attribute information corresponding to the components, such as equipment, pipes and walls, in the model files are obtained and stored in a dictionary container, to make full use of a fast lookup algorithm provided by the container (the algorithm may be implemented by using a solution in conventional art, and details thereof are not described herein).

The geometric vector information and attribute information of model components in respective BIM model files are compared, where the model components of which the geometric vector information and attribute information are compared with each are located at the same position. Since the alignment identifying modes of geometric components, such as points and lines, are different, the object-oriented polymorphism is adopted to rewrite the two virtual functions "Equals" and "GetHashCode" of the geometric data object class, to meet the requirement of personalized alignment for different components. In the present embodiment, the obtained information is completely compared, mainly by determining whether the obtained information exists in the original file (base file), and whether the obtained information in the original file is consistent with the obtained information in the reference file in a case that the obtained information exists in both the original base file and the reference file. Specifically, if the obtained information does not exist in the original base file but exists in the reference file, a list of newly added component is generated; if the obtained information exists in both the original base file and the reference file, and the obtained information in the original base file is inconsistent with the obtained information in the reference file, a list of changed component is generated; and if the obtained information exists in the original base file but does not exist in the reference file, a list of deleted component is generated.

A change and comparison table of the at least two BIM model files is obtained. That is, the above generated lists are integrated and processed to generate a change and comparison table. The integration process of the lists may be implemented by using multiple conventional technologies, and details thereof are not described herein.

The order of the above embodiments is only for convenience of description and does not represent the merits of the embodiments.

Finally, it should be noted that the above embodiments are only used to illustrate the technical solution of the present disclosure but are not meant to limit the disclosure. Although the present disclosure is described in detail with reference to the foregoing embodiments, it should be understood by those skilled in the art that the technical solutions described in the foregoing embodiments may be modified, or some of the technical features may be substituted by equivalents thereof. These modifications and substitutions do not deviate essence of corresponding technical solutions from the spirit and scope of the technical solutions of the embodiments of the present disclosure.

## Claims

1. A method for checking whether a BIM model file is changed, comprising at least the following steps of:
determining one of at least two to-be-checked BIM model files as a base file;
performing an initial data processing on the at least two to-be-checked BIM model files;
obtaining geometric vector information and attribute information of each model component in the BIM model files;
comparing the geometric vector information and attribute information of model components at the same position in respective BIM model files; and
obtaining a change and comparison table of the at least two BIM model files.

2. The method for checking whether a BIM model file is changed according to claim 1, wherein hash algorithm is used to process the BIM model files in the initial data processing.

3. The method for checking whether a BIM model file is changed according to claim 1, wherein information generated in the steps is all stored in a container generated by the hash algorithm.

4. The method for checking whether a BIM model file is changed according to claim 2 or 3, wherein steps of deducing a digital dictionary are protected in the hash algorithm.

5. The method for checking whether a BIM model file is changed according to claim 1, wherein comparing the geometric vector information and attribute information of the model components at the same position in respective BIM model files comprises comparison to identify addition, deletion and consistency, comprising:
generating a list of newly added component, in a case that a component does not exist in the original base file and exists in a reference file;
generating a list of changed component, in a case that the component exists in both the original base file and the reference file and the component in the original base file is inconsistent with the component in the reference file; and
generating a list of deleted component, in a case that the component exists in the original base file and does not exist in the reference file.
